# EUROPÄISCHE PATENTSCHRIFT

(11) **EP 2 984 204 B1**
(45) Veröffentlichungstag und Bekanntmachung des Hinweises auf die Patenterteilung: **04.10.2017**
(21) Anmeldenummer: 14734723.1
(22) Anmeldetag: 10.04.2014
(51) Int. Cl.: C23C 14/56, C23C 16/54

(54) **VORRICHTUNG ZUM BEARBEITEN VON FLEXIBLEN SUBSTRATEN**
DEVICE FOR PROCESSING FLEXIBLE SUBSTRATES
DISPOSITIF DE TRAITEMENT DE SUBSTRATS FLEXIBLES

(30) Priorität: 10.04.2013 DE 102013103590
(43) Veröffentlichungstag der Anmeldung: 17.02.2016
(73) Patentinhaber: Beier, Uwe, 01458 Ottendorf-Okrilla (DE)
(72) Erfinder: Beier, Uwe, 01458 Ottendorf-Okrilla (DE)
(74) Vertreter: Riechelmann & Carlsohn Patentanwälte
(86) Internationale Anmeldenummer: PCT/DE2014/100125
(87) Internationale Veröffentlichungsnummer: WO 2014/166482

(56) Entgegenhaltungen:
- EP-A1- 1 589 130
- EP-A1- 1 988 186
- JP-A- S6 320 465
- JP-A- 2002 212 744
- JP-A- 2013 021 039

## Beschreibung

Die Erfindung betrifft eine Vorrichtung zum Bearbeiten flexibler Substrate.

Flexible Substrate können aus den vielfältigsten Materialien bestehen, die bekanntesten sind Kunststoffe und Metalle, zunehmend sind auch Glasfaser-, Carbon-, Hybrid- und sogar Glasmaterialien in flexibler Form erhältlich. Die flexiblen Substrate werden üblicherweise in Form einer Rolle (die auch als Coil bezeichnet wird) transportiert und aufbewahrt. Für die Bearbeitung werden die flexiblen Substrate von einem ersten Coil, der auf einem Abwickler gelagert ist, abgewickelt, in der Prozess-Sektion bearbeitet und danach auf einem anderen, zweiten Coil, der auf einem Aufwickler gelagert ist, wieder aufgewickelt - daher auch der Name Rolle-zu-Rolle. Dies bedeutet, dass für eine Bearbeitungsmaschine für flexible Substrate jeweils zwei solcher Wickelstationen notwendig sind.

Bekannt sind Bearbeitungsanlagen für flexible Substrate in einem abgeschlossenen Raum, und zwar in unterschiedlichen Ausführungsformen und Gestaltungen. Bekannt sind dabei insbesondere diese zwei Hauptgruppen: Inline- und Batch-Anlagen. Bei einer Inline-Anlage werden die Substrate von außen (atmosphärenseitig) über ein Schleusensystem permanent in die Anlage geführt und nach der Bearbeitung über ein ebensolches wieder zurück an die Atmosphäre befördert. Solche Anlagen sind zumeist für robuste flexible Materialien geeignet. Bei einer Batch-Anlage befinden sich hingegen beide Wickelstationen innerhalb des geschlossenen Raumes, welcher geöffnet werden kann bzw. muss, um die beiden Coils zu wechseln. Dabei wird der Öffnungszyklus maßgeblich durch die Länge des Substrats auf dem Coil sowie den notwendigen Arbeiten zum Wechseln bestimmt. Bisher bekannte Batch-Anlagen bestehen entweder: (i) aus einer Kammer (im Folgenden auch als Einkammer-Batch-Anlage bezeichnet) oder (ii) aus mehreren Kammern (im Folgenden auch als Mehrkammer-Batch-Anlage bezeichnet).

Einkammer-Batch-Anlagen erfordern ein möglichst umfangreiches Öffnen der Kammern, um die Coils wechseln zu können, da die Wickelsektionen nicht von der Prozess-Sektion abtrennbar sind. Dazu müssen jedoch die Bedingungen im Prozessbereich bei jedem Coilwechsel geändert werden, d. h. auf Atmosphärenbedingungen gebracht werden, was zeitaufwendig ist. Es ist darüber hinaus für die Prozesskomponenten und für sensible Prozesse nicht vorteilhaft, wenn zum Coilwechsel die gesamte Kammer geöffnet und damit auf Atmosphärenbedingungen gebracht werden muss. Weiterhin ist für die Zustandsänderung der gesamten Prozesskammer für jeden Coilwechsel ein hoher energetischer Aufwand notwendig, welcher sich in entsprechenden Betriebskosten der Anlage widerspiegelt. Bekannte Einkammer-Batch-Anlagen in Rohrform besitzen erhebliche Defizite hinsichtlich Zugänglichkeit und eignen sich maximal für Laboranlagen und kleinere Produktionsanlagen mit schmalen Substratbreiten.

Eine Einkammer-Batch-Anlage wird beispielsweise in DE 11 2008 001 359 T5 beschrieben.

Mehrkammer-Batch-Anlagen verfügen in der Regel über eine oder zwei zusätzliche Kammern, die häufig als Wickelkammern oder Load-Lock-Kammern bezeichnet werden und die entsprechend zwei bzw. ein Coil enthalten und über ein verschließbares Ventil mit der Prozesskammer verbunden sind. Der Vorteil dieser Lösung besteht darin, dass die Bedingungen in der mittleren Prozesskammer nicht verändert werden müssen, wenn die Coils gewechselt werden. Beispielsweise kann die Prozesskammer unter Prozessdruck bleiben, während die Load-Lock-Kammern auf Atmosphärendruck gebracht werden. Nachteile dieser Variante sind die hohen Investitions- und Betriebskosten, der hohe Platzbedarf sowie der hohe Installations- und Inbetriebnahmeaufwand, da die Justage des Bandlaufs bei diesen Systemen regelmäßig schwierig zu beherrschen ist. Der hohe Platzbedarf ist insbesondere nachteilig in den Reinräumen von Labor- bzw. Produktionsumgebungen, da dort der Platz (der dort auch als "Floorspace" bezeichnet wird) besonders teuer ist. Auch die Zugänglichkeit zur Prozesskammer ist bei den bisher bekannten Lösungen erheblich eingeschränkt. Insgesamt sind Mehrkammer-Batch-Anlagen hinsichtlich des Platzbedarfes und der Investitionskosten gegenüber Einkammer-Batch-Anlagen erheblich im Nachteil. Ihr Vorteil besteht in der Tatsache, dass die Prozesskammer von den Wickelsektionen mittels Ventilen abgetrennt werden kann.

Aus DE 693 32 355 T2 ist eine Vorrichtung zur Vakuumbeschichtung von Aluminiumbändern bekannt. Die Vorrichtung weist eine Abwickelkammer, in die ein Aluminiumcoil zur Beschichtung in der Vorrichtung eingebracht wird, einen Vakuumraum, der in mehrere Vakuumkammern unterteilt ist und in der die Beschichtung durchgeführt wird, und eine Aufwickelkammer auf, aus der ein Coil mit dem beschichteten Aluminiumband entnommen werden kann. Innerhalb des Vakuumraumes wird das Aluminiumband, abgesehen vom Eintritt in den Vakuumraum und dem Austritt aus dem Vakuumabraum ohne Richtungsänderung, d. h. in einer Ebene, geführt. Dazu sind Stützrollen in dem Vakuumraum vorgesehen. Über diese Stützrollen wird das unmittelbar zuvor beschichtete Aluminiumband geführt, wobei die Stützrollen die auf das Aluminiumband aufgebrachte Beschichtung berühren. Eine mechanische Einwirkung kann eine Beeinträchtigung der Beschichtung zur Folge haben. Überdies ist die Vorrichtung nur für die Beschichtung von Substratbändern geeignet, die über lange Strecken gezogen werden können. Die freien Längen, d. h. die Strecken, die ein Band ohne zusätzliche Unterstützung durch eine angetriebene Rolle zurücklegen muss, sind hoch. Um über lange Strecken gezogen werden zu können, müssen die Substratbänder eine hohe Stabilität aufweisen, um die auftretenden Zugkräfte ohne Beeinträchtigung zu überstehen. Diese Bedingung erfüllen nur stabile Substratbänder aus Metall. Substratbänder aus Kunststoff mit einer Stärke von 50 Mikrometern und weniger, beispielsweise nur 5 Mikrometern, können mit dieser Vorrichtung nicht bearbeitet werden. Außerdem erfolgt die Bearbeitung des Aluminiumbandes, d. h. hier die Beschichtung, im sogenannten "Freespan". Als "Freespan" werden Bereiche, insbesondere Prozessbereiche, bezeichnet, in denen das Substratband ohne Unterstützung von Rolle zu Rolle läuft. Das Führen des Substratbandes durch Prozessbereiche, also Bereiche, in denen das Substratband bearbeitet wird, im Freespan kann jedoch zu einer thermischen oder mechanischen Belastung oder beidem führen, weil sich das Substratband im Freespan nicht temperieren lässt. Schließlich weist in DE 693 32 355 T2 jede der Wicklerkammern, also die Abwickelkammer und die Aufwickelkammer, eine separate Vakuumkammer auf, die mittels einer Druckdichtung von dem Raum, in der sich das Coil befindet, abgegrenzt werden kann. Damit soll erreicht werden, dass die Wickelkammern geöffnet werden können. Um das Substratband von der Abwickelkammer in den Vakuumraum zu führen, in dem die Bearbeitung des Bandes erfolgen soll, muss das Substratband vom Coil durch die Vakuumkammer der Abwickelkammer geführt werden, um von dort über eine Rollendichtung in den Vakuumraum zu gelangen. Nach der Bearbeitung im Vakuumraum muss das bearbeitete Band zunächst aus dem Vakuumraum über eine weitere Rollendichtung in die Vakuumkammer der Aufwickelkammer und von dort zum Coil geführt werden. Besonders nachteilig ist, dass in der Vakuumkammer der Abwickelkammer neben Wickelkomponenten auch noch Prozesstechnik, nämlich eine Heizeinrichtung untergebracht ist. Die zusätzlichen Vakuumkammern erhöhen den Platzbedarf der Vorrichtung, so dass mehr Aufstellfläche erforderlich ist. Überdies müssen die Kammern der Vorrichtung zueinander ausgerichtet werden, um einen ausreichend exakten Bahnlauf zu gewährleisten.

Aus DE 10 2005 058 869 A1 ist eine weitere Vorrichtung zum Beschichten von Substratbändern bekannt. Auch diese Vorrichtung ist auf die Beschichtung von Substratbändern aus Metall ausgerichtet. Das Substratband wird über lange Strecken gezogen, die freien Längen sind hoch. Daher sind stabile Substratbänder erforderlich. Die Beschichtung wird ebenfalls im Freespan durchgeführt. Außerdem weisen die Wickelkammern ebenfalls separate Vakuumkammern auf, die die obengenannten Nachteile besitzen. Überdies weist die Vorrichtung noch sogenannte Verbindungskanäle auf, die die Wicklerkammern mit den Prozesskammern verbinden, was den Platzbedarf dieser Vorrichtung weiter erhöht.

JP63 020 465 A offenbart eine Vorrichtung zum Bearbeiten flexibler, bandförmiger Substrate. Die Vorrichtung umfasst eine T- förmige Kammer, einen Abwickler und einen Aufwickler in Wicklergehäuse ausserhalb der Kammer, Mittel zur Führung des flexiblen Substrates vom Abwickler zum Aufwickler und abgedichtete Durchführungen. Aufgabe der Erfindung ist es, die Nachteile nach dem Stand der Technik zu beseitigen. Es soll insbesondere eine Vorrichtung zur Bearbeitung flexibler Substrate angegeben werden, die einen geringen Platzbedarf und eine verbesserte Zugänglichkeit der Prozesskammer aufweist.

Diese Aufgabe wird durch die Merkmale des Anspruch 1 gelöst. Zweckmäßige Ausgestaltungen der Erfindungen ergeben sich aus den Merkmalen der Unteransprüche.

Nach Maßgabe der Erfindung ist eine Vorrichtung zum Bearbeiten flexibler, bandförmiger Substrate vorgesehen, wobei die Vorrichtung eine Kammer für die Bearbeitung des flexiblen Substrates, einen Abwickler und einen Aufwickler für das flexible Substrat, die außerhalb der Kammer angeordnet sind, sowie Mittel zur Führung des flexiblen Substrates vom Abwickler zum Aufwickler aufweist, wobei die Kammer zumindest eine abgedichtete Durchführung zum Führen des flexiblen Substrates in die Kammer und/oder aus der Kammer besitzt, dadurch gekennzeichnet, dass die Kammer einen Hauptbereich und zumindest einen Übergangsbereich aufweist, dessen Ausdehnung in zumindest einer Richtung geringer als die Ausdehnung des Hauptbereiches in derselben Richtung ist. Diese Richtung wird im Folgenden als Bezugsrichtung bezeichnet. Darüber hinaus ist vorgesehen, dass der Abwickler und der Aufwickler an der Außenwand der Kammer befestigt sind.

Vorzugsweise sind der Abwickler und der Aufwickler in einem gemeinsamen Wicklergehäuse oder separaten Wicklergehäusen angeordnet. Ferner kann vorgesehen sein, dass an den kanalförmigen Übergangsbereich ein Wicklergehäuse angrenzt und die Ausdehnung des Wicklergehäuses die Ausdehnung des kanalförmigen Übergangsbereiches in der Bezugsrichtung nicht übersteigt.

Im Folgenden wird der kanalförmige Übergangsbereich als Übergangsbereich bezeichnet.

Der Übergangsbereich sollte an den Hauptbereich angrenzen. Vorzugsweise weist die erfindungsgemäße Vorrichtung zwei Übergangsbereiche auf, zwischen denen der Hauptbereich liegt. Es kann jedoch vorgesehen sein, dass die erfindungsgemäße Vorrichtung nur einen Übergangsbereich aufweist. Dies ist insbesondere dann vorteilhaft, wenn der Abwickler und der Aufwickler in einem gemeinsamen Wicklergehäuse angeordnet sind.

Sind zwei Übergangsbereiche vorgesehen, so können sie in derselben Höhe oder versetzt zueinander, jeweils bezogen auf die genannte Richtung, ausgebildet sein. Vorzugsweise sind die beiden Übergangsbereiche an gegenüberliegenden Seiten der Kammer ausgebildet. Die beiden Übergangsbereiche weisen vorzugsweise die gleichen Dimensionen auf.

Sind zwei oder mehr Übergangsbereiche vorgesehen, so weisen alle Übergangsbereiche in der Bezugsrichtung eine geringere Ausdehnung als der Hauptbereich auf. Zweckmäßigerweise weisen alle Übergangsbereiche die gleiche Ausdehnung in der Bezugsrichtung auf.

Ist nur ein Übergangsbereich vorgesehen, so weisen der Hauptbereich und der Übergangsbereich zweckmäßigerweise eine gemeinsame Oberkante auf. Sind zwei Übergangsbereiche vorgesehen, die an einen Hauptbereich angrenzen, so weisen der Hauptbereich und beide Übergangsbereiche vorzugsweise eine gemeinsame Oberkante auf. Auf diese Weise wird eine T-förmige Kammer erhalten. Es kann aber auch vorgesehen sein, dass nur einer der Übergangsbereiche eine gemeinsame Oberkante mit dem Hauptbereich hat, während der andere Übergangsbereich eine Oberkante besitzt, die unterhalb der Oberkante des Hauptbereiches verläuft. Dabei bezieht sich der Bestandteil "oben" im Ausdruck "Oberkannte" lediglich auf die Bezugsrichtung.

Vorzugsweise wird das flexible Substrat durch einen der Übergangsbereiche zu dem Hauptbereich geführt. Ist nur ein Übergangsbereich vorgesehen, so wird das flexible Substrat zweckmäßigerweise von dem Abwickler durch den Übergangsbereich zum Hauptbereich und vom Hauptbereich durch den Übergangsbereich zum Aufwickler geführt. Sind zwei Übergangsbereiche vorgesehen, so wird das flexible Substrat zweckmäßigerweise von dem Abwickler durch den ersten Übergangsbereich zum Hauptbereich und vom Hauptbereich durch den zweiten Übergangsbereich zum Aufwickler geführt.

Der Hauptbereich und der oder die Übergangsbereiche, die an diesen Hauptbereich angrenzen, sind innerhalb der Kammer vorzugsweise nicht voneinander getrennt. Es kann aber alternativ vorgesehen sein, dass der oder die Übergangsbereiche von dem Hauptbereich durch jeweils eine Wand getrennt sind, in denen abgedichtete Durchführungen für das flexible Substrat vorgesehen sind.

In einer Ausführungsform der Erfindung grenzt das Wicklergehäuse des Abwicklers an den ersten Übergangsbereich, während das Wicklergehäuse des Aufwicklers an den zweiten Übergangsbereich angrenzt. In einer anderen Ausführungsform grenzt das Wicklergehäuse des Abwicklers an den ersten Übergangsbereich an, während der zweite Übergangsbereich an einen weiteren Hauptbereich angrenzt.

Das oder die Wicklergehäuse grenzen vorzugsweise an die Seite des Übergangsbereiches an, die dem Hauptbereich abgewandt ist. Auf diese Weise wird sichergestellt, dass die Zugänglichkeit der Kammer über den Hauptbereich so gering wie möglich durch die Wicklergehäuse eingeschränkt wird. Alternativ kann vorgesehen sein, dass die Wicklergehäuse direkt an den Hauptbereich angrenzen, beispielsweise an dessen Oberkante.

Die erfindungsgemäße Vorrichtung kann mehr als einen Hauptbereich aufweisen. In diesem Fall ist zwischen benachbarten Hauptbereichen jeweils ein Übergangsbereich vorgesehen. Auf diese Weise kann eine Kammer erhalten werden, die mehrere Bearbeitungsprozesse ermöglicht. Zwischen benachbarten Hauptbereichen können abgedichtete Durchführungen, beispielsweise Ventile oder auch Strömungswiderstände, ausgebildet sein. Auf diese Weise können in verschiedenen Hauptbereichen unterschiedliche Prozessbedingungen geschaffen werden, beispielsweise unterschiedliche Temperaturen, Drücke und/oder Gaszusammensetzungen. Sind mehrere Hauptbereiche vorgesehen, so befindet sich zweckmäßigerweise an dem Übergangsbereich des ersten Hauptbereiches der Abwickler, während am Übergangsbereich des letzten Hauptbereiches der Aufwickler angeordnet ist. Die Übergangsbereiche zwischen benachbarten Hauptbereichen weisen zweckmäßigerweise eine geringere Ausdehnung in der Bezugsrichtung als die ihr benachbarten Hauptbereiche auf.

Der Ausdruck "Wicklergehäuse" bezeichnet dabei ein Gehäuse, in dem sich der Abwickler, der Aufwickler oder beide befinden. Vorzugsweise sind der Abwickler, der Aufwickler oder beide an der Außenwandung der Kammer an den Übergangsbereichen befestigt. Es ist nicht erforderlich, separate Kammern oder Gestelle für den Abwickler oder den Aufwickler vorzusehen, die den Aufwickler, den Abwickler oder beide unabhängig von der Kammer halten, in der das Substrat bearbeitet werden soll. Ausreichend ist es vielmehr, wenn der Abwickler, der Aufwickler oder, was bevorzugt ist, beide direkt an der Kammer der erfindungsgemäßen Vorrichtung befestigt werden.

Innerhalb der Wicklergehäuse können Mittel zur Änderung der Ausrichtung der Substratbahn von einer ersten Ebene in eine zweite, orthogonale Ebene vorgesehen sein. Diese Umlenkung wird im Folgenden auch als "90°-Umlenkung" bezeichnet. Geeignete Mittel sind beispielsweise Umlenkrollen oder -walzen. Eine solche Umlenkung ist insbesondere dann zweckmäßig, wenn der vertikale Bahnlauf in der Prozess-Sektion an den beiden Enden für den Abwickler und den Aufwickler in einen horizontalen Bahnlauf umgelenkt werden soll. Damit kann einerseits erreicht werden, dass sich an den Coils die aus der Standard-Lösung bekannten Gegebenheiten einstellen, zum anderen können die Coils dann einfach und wie gewohnt mit einem Hebezeug, beispielsweise einem Kran gewechselt werden. Zusätzlich kann erreicht werden, dass die Prozesstechnik an separaten Türen am Hauptbereich angebracht werden kann, welche sich dann auf einfache Weise öffnen lassen. Beispielsweise können die Türen auf einem Wagen befestigt sein, welcher auf Schienen läuft, es kann aber beispielsweise auch ein Gabelstapler genutzt werden. Insgesamt bietet diese Ausführungsform eine gute Zugänglichkeit zum Hauptbereich, was eine einfache Bedienung und einen einfacheren Service erlaubt.

Im Gegensatz zum Stand der Technik weisen die Wicklergehäuse keine Zwischenkammern oder separaten Vakuumkammern auf, die von den Coils abtrennbar sind und in denen Temperatur- und/oder Druckverhältnisse geschaffen werden können, die sich von dem Raum unterscheiden, in dem sich das Coil befindet.

Die erfindungsgemäße Vorrichtung kann mehr als einen Abwickler, mehr als einen Aufwickler oder beides aufweisen.

Die maximale Ausdehnung des oder der Übergangsbereiche in der Bezugsrichtung kann 50 % der Ausdehnung des Hauptbereiches in der Bezugsrichtung betragen. In diesem Fall ist die Ausdehnung des Hauptbereiches das Doppelte der Ausdehnung des oder der Übergangsbereiche. Es kann vorgesehen sein, dass die maximale Ausdehnung des oder der Übergangsbereiche in der Bezugsrichtung weniger als 50 %, beispielsweise ein Drittel oder weniger der Ausdehnung des Hauptbereiches in der Bezugsrichtung beträgt.

Die Ausdehnung des oder der Übergangsbereiche in einer Richtung orthogonal zur Bezugsrichtung entspricht vorzugsweise der Ausdehnung des Hauptbereiches in dieser orthogonalen Richtung.

In einer bevorzugten Ausführungsform weist die Kammer einen T-förmigen Querschnitt auf. Sie kann aber auch andere Querschnitte, beispielsweise einen kreuzförmigen Querschnitt aufweisen. Durch die optimale Anpassung des Hauptbereiches, der die Prozesssektion der Kammer bildet, an den abzubildenden Prozess kann die Geometrie dieser Prozesssektion erheblich variieren. Beispielsweise kann sie rund, eckig, schräg ausgeführt werden, wobei die Aufzählung nicht abschließend ist. Auch die geometrische Gestaltung der mindestens einen, meist jedoch zwei Wicklergehäuse, die die Wickelsektionen der Vorrichtung bilden, kann ja nach Randbedingungen wie Coilabmessungen, Kranhöhe, Bühnenhöhe usw. unterschiedlichste Ausführungsformen aufweisen, beispielsweise eine horizontale, vertikale oder schräge Tür.

Zweckmäßigerweise sind in dem oder den Wicklergehäusen verschließbare Öffnungen ausgebildet, die eine Ein- oder Ausbringung von Rollen des flexiblen Materials gestatten. Beispielsweise können Türen in den Wicklergehäusen vorgesehen sein. Zweckmäßigerweise sind die verschließbaren Öffnungen so ausgebildet, dass die Coils mittels eines Hebewerkzeuges aus den Wicklergehäusen entnommen oder in diese eingebracht werden können. In einer Ausführungsform der Erfindung kann es ausreichend sein, wenn nur eine verschließbare Öffnung vorgesehen ist, wenn über diese Öffnung sowohl ein Coilwechsel am Abwickler als auch ein Coilwechsel am Aufwickler vorgenommen werden kann. Dies ist beispielsweise dann der Fall, wenn der Aufwickler und der Abwickler in einem gemeinsamen Wicklergehäuse angeordnet sind.

Die Türen in den Wicklergehäusen können schwenkbar sein. Sie können sich beispielsweise nach oben, unten oder zur Seite öffnen lassen.

In der Kammer können Bedingungen geschaffen werden, die sich von denen der Umgebung unterscheiden. Beispielsweise können sich Druck, Temperaturen und/oder die Zusammensetzung eines Gasgemisches, das sich in der Kammer befindet, von der Umgebung unterscheiden. Über die abgedichteten Durchführungen kann das flexible Substrat in die Kammer geführt werden. Es ist nicht zwingend erforderlich, in den Wicklergehäusen Bedingungen zu schaffen, die sich von denen der Umgebung unterscheiden. Aus diesem Grund ist ein einfacher Zugriff über die verschließbaren, beispielsweise mit Türen versehenen Öffnungen auf den Abwickler und/oder den Aufwickler möglich. Ein Coilwechsel erfordert somit keine Änderung der in der Kammer herrschenden Bedingungen, d. h. die Prozesssektion bleibt während eines solchen Wechsels unbeeinflusst.

Das Substrat soll innerhalb der Kammer bearbeitet werden. Dazu können Bearbeitungseinrichtungen in der Kammer angeordnet sein. Zweckmäßigerweise befinden sich die Bearbeitungseinrichtungen nur im Hauptbereich der erfindungsgemäßen Vorrichtung oder im Hauptbereich und in den Übergangsbereichen der erfindungsgemäßen Vorrichtung. Ferner befinden sich in der erfindungsgemäßen Vorrichtung Mittel zur Führung des flexiblen Substrates, beispielsweise Führungsrollen, die sich drehen können, und Hilfsrollen, die starr angeordnet sind. Die Mittel zur Führung des flexiblen Substrates sollten so angeordnet sein, dass die freien Längen möglichst gering sind. Vorteilhafterweise ist zumindest ein Teil dieser Mittel angetrieben. Damit wird die Zugbelastung des flexiblen Substrates vermindert. Vorteilhafterweise sind die Mittel zur Führung des flexiblen Substrates so angeordnet, dass die Flächenseite des flexiblen Substrates, die einer Bearbeitung unterzogen werden soll und/oder worden ist, in der Kammer nicht in Kontakt mit einem dieser Mittel gelangt.

In einer bevorzugten Ausführungsform ist in einer Kammer eine Prozesswalze angeordnet, an der das flexible Substrat mit einer Flächenseite anliegt, während die andere Flächenseite mittels der Bearbeitungseinrichtung bearbeitet wird. Vorzugsweise handelt es sich bei der Prozesswalze um eine temperierbare Prozesswalze, so dass das flexible Substrat, solang es an der Prozesswalze anliegt, temperiert, d. h. erwärmt oder gekühlt werden kann. Die Prozesswalze ist vorteilhafterweise im Hauptbereich der Kammer angeordnet. Vorzugsweise sind die Bearbeitungseinrichtungen in der Hauptkammer derart angeordnet, dass das flexible Substrat einer Bearbeitung unterzogen werden kann, wenn es an der Prozesswalze anliegt. Die Prozesswalze vermindert die Zugbelastung des flexiblen Substrates. Sie sorgt ebenfalls für geringe freie Längen. Zur weiteren Verringerung der Zugbelastung des flexiblen Substrates kann die Prozesswalze eine angetriebene Walze sein.

Die Prozesswalze bietet den Vorteil, dass während der Bearbeitung des flexiblen Substrates der sogenannte Freespan vermieden wird. Die Prozesswalze kann das flexible Substrat, das an ihr anliegt, insbesondere während der Bearbeitung temperieren und gleichzeitig führen.

Alternativ oder zusätzlich zu einer Prozesswalze können in der Kammer Stützwalzen vorgesehen sein, um den Freespan auch während der Bearbeitung des flexiblen Substrates möglichst kurz zu halten.

Im Hauptbereich befinden sich die Bearbeitungseinrichtungen vorzugsweise in einem Teilbereich des Hauptbereiches, der nicht an den oder die Übergangsbereiche angrenzt. Auf diese Weise wird die Zugänglichkeit zu den Bearbeitungseinrichtungen weiter vereinfacht. Der Teilbereich des Hauptbereiches, der an den oder die Übergangsbereiche angrenzt, kann das Wickelwerk oder Teile davon aufnehmen.

Die erfindungsgemäße Vorrichtung ermöglicht eine räumliche Trennung der Abschnitte Abwickler/Prozess/Aufwickler sowie die Optimierung auf den Prozess, d. h. die Bearbeitung eines flexiblen Substrates. Im Gegensatz dazu muss bei einer rohrförmigen Kammer der Prozess an die Kammerform angepasst werden. Als besonders vorteilhaft hat sich erwiesen, wenn die Kammer der erfindungsgemäßen Vorrichtung T-förmig ist, d. h. zwei Übergangsbereiche vorgesehen sind, zwischen denen sich der Hauptbereich befindet. Die Wandung des Hauptbereiches der Kammer, die den Teilbereich, in dem die Bearbeitungseinrichtungen angeordnet sind, umgibt, kann so geformt sein, dass sie dem Verlauf der Bahn des flexiblen Substrates in diesem Teilbereich folgt. Im Falle einer Prozesswalze kann die Wandung des Hauptbereiches also gekrümmt sein. Die Krümmung kann dabei konzentrisch zur Prozesswalze sein. Das kann auch vorteilhaft sein, wenn die Bahn des flexiblen Substrates mittels Stützwalzen auf einer gekrümmten Bahn geführt wird. Entspricht die Geometrie der Kammer dem Bahnverlauf des flexiblen Substrates in der Kammer und der Anordnung der Bearbeitungseinrichtungen so kann eine besonders kompakte Vorrichtung erhalten werden. Der Platzbedarf einer solchen Vorrichtung ist gering.

Innerhalb des Hauptbereiches und vorzugsweise in dem Teilbereich des Hauptbereiches, der nicht an den oder die Übergangsbereiche angrenzt, können mehrere Prozessstationen angeordnet sein. In jeder Prozessstation befindet sich zumindest eine Bearbeitungseinrichtung zur Bearbeitung des flexiblen Substrates. Alle Prozessstationen weisen vorzugsweise die gleichen Abmessungen auf. Vorteilhafterweise grenzen die Prozessstationen aneinander.

Die erfindungsgemäße Vorrichtung verfügt nur über eine einzige Kammer. Diese Kammer weist einen Hauptbereich und zumindest einen Übergangsbereich auf. Da nur eine Kammer erforderlich ist, erfordert die erfindungsgemäße Vorrichtung nur eine minimale Aufstellfläche, was wiederum die Investitionskosten minimiert.

Die Gestaltung der Kammer mit einem Hauptbereich und zumindest einem Übergangsbereich, der erfindungsgemäß eine geringe Ausdehnung in der Bezugsrichtung aufweist, ermöglicht es, ein kompaktes Wickelwerk innerhalb der Kammer zu realisieren, so dass eine maximale Wickelpräzision erreicht wird. Eine Ausrichtung von mehreren Wickelwerken zueinander ist nicht erforderlich. Ebenso wird ein ausgezeichneter Bahnlauf des flexiblen Substrats von Abwickler zu Aufwickler erreicht, da alle Komponenten an bzw. in der einen Kammer befestigt sind, was eine hohe Stabilität und Präzision der erfindungsgemäßen Vorrichtung ermöglicht. Dadurch reduziert sich der Montage- und Inbetriebnahmeaufwand erheblich, da keine Ausrichtarbeiten zwischen mehreren Kammern vorgenommen werden müssen.

Die Wicklergehäuse sind zweckmäßigerweise so an der Kammer angeordnet, dass sie an einen Bereich der Kammer angrenzen, in denen sich das Wickelwerk befindet. Damit werden die Wege reduziert, die das flexible Substrat zurücklegen muss.

Die Wicklergehäuse sind von der Kammer absperrbar. Zu diesem Zweck können die abgedichteten Durchführungen Ventile aufweisen. Die Ventile werden in der Regel nur gesperrt, wenn kein Substratlauf erfolgt, d. h., die Vorrichtung befindet sich im Stillstand. Nach einem Coilwechsel können dann die Türen in den Wicklergehäusen geschlossen und in den Wicklergehäusen die gleichen Bedingungen wie im Hauptbereich hergestellt werden. Schließlich können die Ventile wieder geöffnet und der Substratlauf zur Bearbeitung des Substrates in der Kammer wieder gestartet werden.

Aufgrund der im Vergleich zum Hauptbereich der Kammer geringen Größe der Wicklergehäuse besteht eine uneingeschränkte Zugänglichkeit zum Hauptbereich der Kammer, in dem der Bearbeitungsprozess stattfinden soll und der somit die Prozesssektion der erfindungsgemäßen Vorrichtung bildet. Die Wicklergehäuse und die darin befindlichen Abwickler und/oder Aufwickler bilden die Wickelsektionen der erfindungsgemäßen Vorrichtung.

Da die Wickelsektionen von der Prozesssektion getrennt sind, können Überschneidungen der Zugänglichkeitsbereiche "Prozess" und "Wickler" verhindert werden. Die Zugänglichkeit der Prozesssektion bleibt während eines Coilwechsels unbeeinflusst.

Insgesamt bietet die erfindungsgemäße Vorrichtung einen guten Zugang zu allen Sektionen, also der Prozesssektion und der zumindest einen Wickelsektion. Im Ergebnis sind die Investitionskosten, die mit der erfindungsgemäßen Vorrichtung verbunden sind, auch aufgrund ihrer geringen Komponentenanzahl gering. Eine einfache, schnelle und sichere Inbetriebnahme ist möglich. Auch die Betriebskosten sind vergleichsweise günstig.

Die erfindungsgemäße Vorrichtung wird zweckmäßigerweise als Batch-Anlage betrieben.

Die erfindungsgemäße Vorrichtung erlaubt die Bearbeitung von flexiblen Substraten, die - im Vergleich zum Stand der Technik - eine geringe Stabilität aufweisen, weil Zugbelastungen minimiert werden. So ist die Vorrichtung beispielsweise nicht nur für die Bearbeitung von flexiblen Substraten aus Metall, sondern auch aus Kunststoff geeignet. Die Vorrichtung ist insbesondere auch zur Bearbeitung von flexiblen Substraten mit Dicken von 5 bis 50 Mikrometern geeignet. Das gilt auch, wenn die Substrate aus Kunststoff bestehen.

Die Erfindung wird nachstehend anhand von Ausführungsbeispielen, die die Erfindung nicht einschränken sollen, unter Bezugnahme auf die Zeichnungen näher erläutert. Dabei zeigen
- Fig. 1: eine schematische Querschnittsdarstellung einer ersten Ausführungsform der erfindungsgemäßen Vorrichtung;
- Fig. 1a: eine schematische Querschnittsdarstellung einer T-förmigen Kammer ähnlich der ersten Ausführungsform, in der die Lage der Bereiche in der Kammer sowie deren Dimensionen veranschaulicht werden;
- Fig. 1b: eine schematische Draufsicht der ersten Ausführungsform der erfindungsgemäßen Vorrichtung;
- Fig. 1c: eine schematische Draufsicht einer Ausführung der erfindungsgemäßen Vorrichtung, die der ersten Ausführungsform entspricht, außer dass die Übergangsbereiche auch in einer Querrichtung zur Be-zugsrichtung kürzer als der Hauptbereich in dieser Querrichtung sind;
- Fig. 2: eine schematische Querschnittsdarstellung einer zweiten Ausführungsform der erfindungsgemäßen Vorrichtung;
- Fig. 2a: eine schematische Querschnittsdarstellung einer T-förmigen Kammer ähnlich der zweiten Ausführungsform, in der die Lage der Bereiche in der Kammer sowie deren Dimensionen veranschaulicht werden;
- Fig. 3: eine schematische Querschnittsdarstellung einer dritten Ausführungsform der erfindungsgemäßen Vorrichtung;
- Fig. 4: eine schematische Querschnittsdarstellung einer vierten Ausführungsform der erfindungsgemäßen Vorrichtung;
- Fig. 5: eine schematische Querschnittsdarstellung einer fünften Ausführungsform der erfindungsgemäßen Vorrichtung;
- Fig. 6: eine schematische Querschnittsdarstellung einer sechsten Ausführungsform der erfindungsgemäßen Vorrichtung;
- Fig. 7: eine schematische Querschnittsdarstellung einer siebten Ausführungsform der erfindungsgemäßen Vorrichtung;
- Fig. 8: eine schematische Querschnittsdarstellung einer achten Ausführungsform der erfindungsgemäßen Vorrichtung;
- Fig. 9: eine schematische Querschnittsdarstellung einer neunten Ausführungsform der erfindungsgemäßen Vorrichtung;
- Fig. 10: eine schematische Querschnittsdarstellung einer zehnten Ausführungsform der erfindungsgemäßen Vorrichtung;
- Fig. 11: eine schematische Querschnittsdarstellung einer elften Ausführungsform der erfindungsgemäßen Vorrichtung;
- Fig. 12: eine schematische Querschnittsdarstellung einer zwölften Ausführungsform der erfindungsgemäßen Vorrichtung;
- Fig. 13: eine schematische Querschnittsdarstellung einer dreizehnten Ausführungsform der erfindungsgemäßen Vorrichtung;
- Fig. 14: eine schematische Querschnittsdarstellung einer vierzehnten Ausführungsform der erfindungsgemäßen Vorrichtung;
- Fig. 14a: eine schematische Querschnittsdarstellung der vierzehnten Ausführungsform der erfindungsgemäßen Vorrichtung, in der zusätzlich die Prozesswalze gezeigt ist;
- Fig. 15: eine schematische Querschnittsdarstellung einer fünfzehnten Ausführungsform der erfindungsgemäßen Vorrichtung;
- Fig. 15a: ein Blick in das Wicklergehäuses des Abwicklers von oben;
- Fig. 15b: eine Darstellung des Abwicklers und der Umlenkrollen, die sich in dem in Fig. 15a gezeigten Wicklergehäuse befinden, von vorn, wobei diese Darstellung auch Darstellung von hinten entspricht;
- Fig. 15c: eine Darstellung des Abwicklers und der Umlenkrollen, die sich in dem in Fig. 15a gezeigten Wicklergehäuse befinden, von links; und
- Fig. 15d: eine schematische Querschnittsdarstellung der fünfzehnten Ausführungsform der erfindungsgemäßen Vorrichtung, in der zusätzlich die Prozesswalze gezeigt ist.

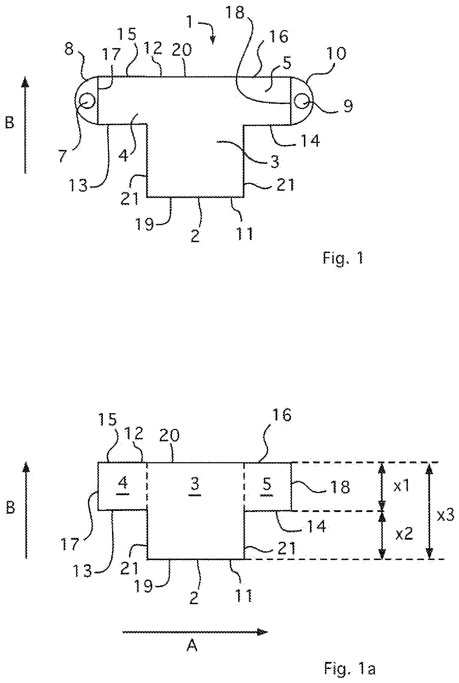

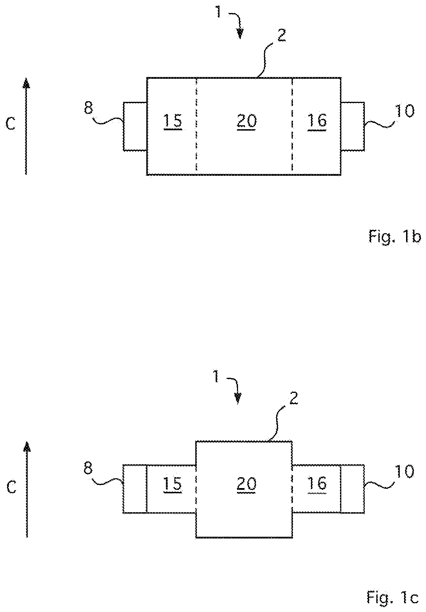

Die in Fig. 1 in vereinfachter Darstellung gezeigte erste Ausführungsform der erfindungsgemäßen Vorrichtung 1 weist eine Kammer 2 mit einem Hauptbereich 3 und zwei daran angrenzenden kanalförmigen Übergangsbereichen 4, 5 auf. Es ist zu erkennen, dass die Ausdehnung der Übergangsbereiche 4, 5 in der Bezugsrichtung (Pfeil B) geringer als die Ausdehnung des Hauptbereiches 3 in dieser Richtung ist. Die Kammer 2 weist daher einen T-förmigen Querschnitt auf. Beide Übergangsbereiche 4, 5 haben die gleichen Dimensionen. Die Kammer 2 hat eine gerade Unterkante 11 und eine gerade Oberkante 12. Dabei beziehen sich die Ausdrücke "oben" und "unten" lediglich auf die Bezugsrichtung. Die Unterkante 11 der Kammer 2 bildet gleichzeitig die Unterkante 19 des Hauptbereiches 3. Die Oberkante 12 bildet die Oberkante des Hauptbereiches 3 und beider Übergangsbereiche 4, 5. Die Übergangsbereiche 4, 5 haben jeweils eine Unterkante 13, 14, die parallel zur Oberkante 12 der Kammer 2 verläuft. Die Querwände 17, 18, 21 der Kammer 2 verlaufen senkrecht zu deren Unterkante 11 und deren Oberkante 12. Die äußeren Querwände 17, 18 der Kammer 2 sind gleichzeitig die äußeren Querwände der Übergangsbereiche 4, 5. In diesen Querwänden 17, 18 befinden sich die mit Ventilen abgedichteten Durchführungen für das flexible Substrat.

An der Kammer 2 ist ein Abwickler 7, der sich der in einem Wicklergehäuse 8 befindet, an der äußeren Querwand 17 und ein Aufwickler 9, der sich in einem Wicklergehäuse 10 befindet, befestigt. Der Abwickler 7 ist dabei an dem ersten Übergangsbereich 4 der Kammer 2 befestigt, und zwar an der Seite des ersten Übergangsbereiches 4, die dem Hauptbereich 3 abgewandt ist. Die Ausdehnung des Wicklergehäuses 8 überschreitet die Ausdehnung des ersten Übergangsbereiches 4 nicht. Der Aufwickler 9 ist dabei an dem zweiten Übergangsbereich 5 der Kammer 2 befestigt, und zwar an der Seite des zweiten Übergangsbereiches 5, die dem Hauptbereich 3 abgewandt ist. Die Ausdehnung des Wicklergehäuses 10 überschreitet die Ausdehnung des zweiten Übergangsbereiches 5 nicht.

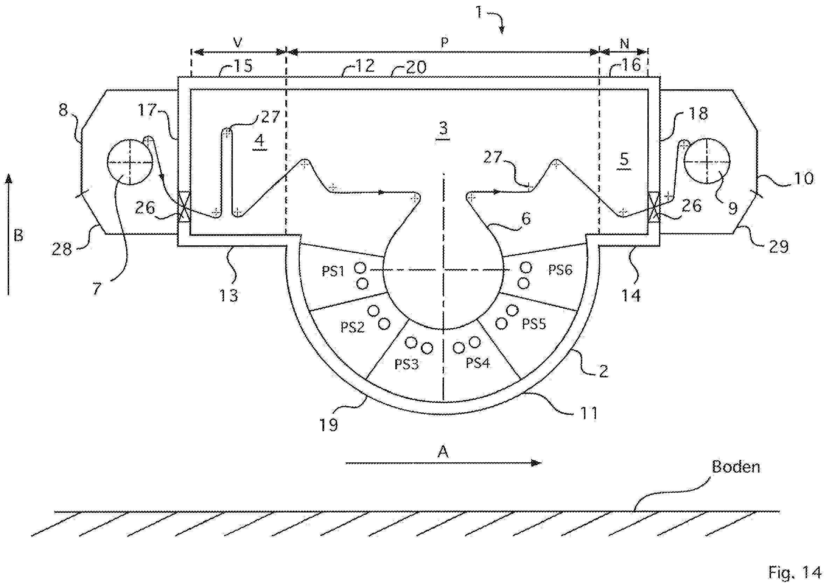

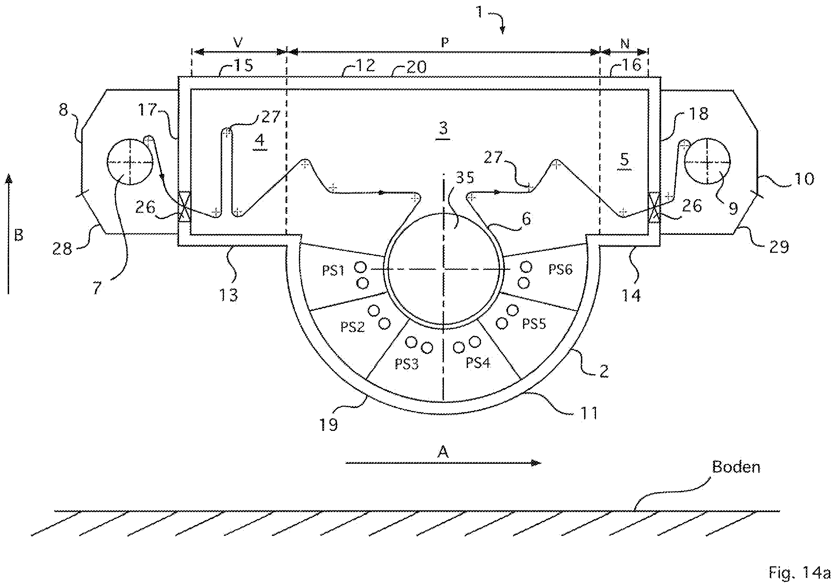

Auf die Wiedergabe von Befestigungselementen für den Abwickler 7 und den Aufwickler 9, des flexiblen bandförmigen Substrates 6, von Mitteln zur Führung des flexiblen Substrates 6 vom Abwickler 7 zum Aufwickler 9, von Einrichtungen zur Bearbeitung des Substrates 6 sowie der mittels Ventilen abgedichteten Durchführungen wurde zur Vereinfachung der Darstellung verzichtet. Derartige Einzelheiten sind in Fig. 14 dargestellt.

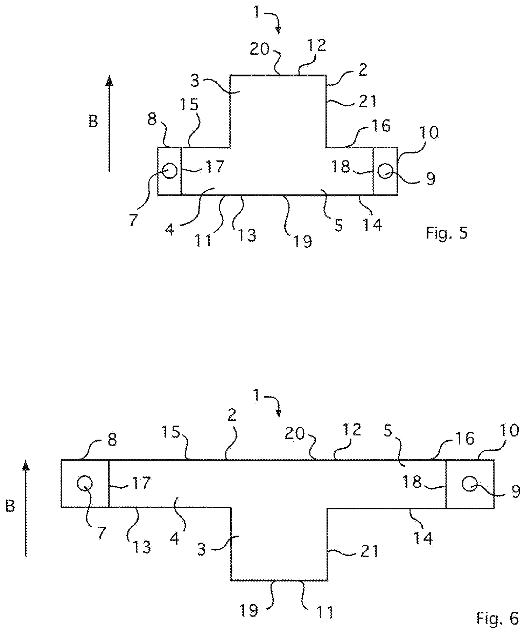

Fig. 1a veranschaulicht die Lage des Hauptbereiches 3 und der Übergangsbereiche 4, 5 in einer T-förmigen Kammer. Zur Veranschaulichung sind in Fig. 1a die Überbereiche 4, 5 vom Hauptbereich 3 durch gestrichelte Linien abgegrenzt, wobei die Linien nicht für reale Wände stehen. In Fig. 1a ist ferner zu erkennen, dass die Ausdehnung x₁ der Übergangsbereiche 4, 5 in der Bezugsrichtung der Hälfte der Ausdehnung x₃ des Hauptbereiches in der Bezugsrichtung entspricht, d. h., die Ausdehnung x₂ des Hauptbereiches 3 von der Unterkante der Kammer 2 bis zu den Unterkanten 13, 14 der Übergangsbereiche 4, 5 entspricht der Ausdehnung x₁ der Übergangsbereiche 4, 5 so dass die Ausdehnung x₃ des Hauptbereiches 2x₁ beträgt. Es versteht sich, dass x₁ und x₂ nicht exakt gleich sein müssen, sondern das Abweichungen davon möglich sind. Vorzugsweise ist x₁ gleich x₂, wobei in Fig. 1 x₁ kleiner als x₂ ist. Die Ausdehnung x₃ des Hauptbereiches ist definiert als die Summe aus x₁ und x₂. In Richtung A, also der Querrichtung zur Bezugsrichtung B in der Papierebene, sollte die Ausdehnung der beiden Übergangsbereiche 4, 5 kleiner als die des Hauptbereiches sein. Das ist jedoch nicht zwingend erforderlich, wie Fig. 6 zeigt.

Fig. 1b zeigt eine Draufsicht der in Fig. 1 gezeigten Ausführungsform, in der zu erkennen ist, dass die Übergangsbereiche 4, 5 und der Hauptbereich 3 in Richtung C, die orthogonal zur Bezugsrichtung B und Richtung A verläuft, die gleiche Ausdehnung haben. Fig. 1c zeigt eine Draufsicht der in Fig. 1 gezeigten Ausführungsform, in der zu erkennen ist, dass die Ausdehnung der Übergangsbereiche 4, 5 geringer als die Ausdehnung des Hauptbereichs 3 in Richtung C ist. In den Fig. 1b und 1c veranschaulichen die gestrichelten Linien lediglich die Grenzen der Bereiche 3, 4, 5.

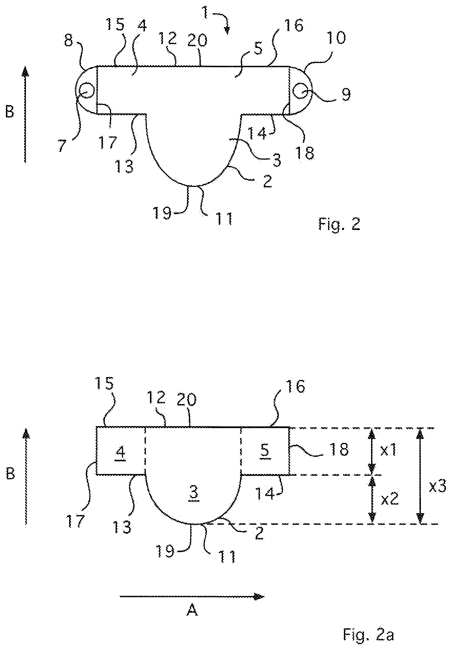

Die in Fig. 2 in vereinfachter Darstellung gezeigte zweite Ausführungsform der erfindungsgemäßen Vorrichtung 1 entspricht der in Fig. 1 gezeigten ersten Ausführungsform, außer dass die Unterkante 11 der Kammer 2, die gleichzeitig die Unterkante 19 des Hauptbereiches 3 ist, gekrümmt ist. Dabei erstreckt sich die gekrümmte Unterkante 18 des Hauptbereiches 3 bis zu den Unterkanten 13, 14 der Übergangsbereiche 4, 5, so dass der Hauptbereich 3 keine Querwände aufweist.

Fig. 2a veranschaulicht die Lage des Hauptbereiches 3 und der Übergangsbereiche 4, 5 in einer T-förmigen Kammer mit halbkreisförmiger Unterkannte 11 der Kammer 2. Zur Veranschaulichung sind in Fig. 1b die Überbereiche 4, 5 vom Hauptbereich 3 durch gestrichelte Linien abgegrenzt, wobei die Linien nicht für reale Wände stehen. In Fig. 2a ist ferner zu erkennen, dass die Ausdehnung x₁ der Übergangsbereiche 4, 5 in der Bezugsrichtung der Hälfte der Ausdehnung x₃ des Hauptbereiches 3 in der Bezugsrichtung entspricht, d. h., die Ausdehnung x₂ des Hauptbereiches 3 von der Unterkante der Kammer 2 bis zu den Unterkanten 13, 14 der Übergangsbereiche 4, 5 entspricht der Ausdehnung x₁ der Übergangsbereiche 4, 5, so dass die Ausdehnung des Hauptbereiches 2x₁ beträgt. Die Ausdehnung x₂ wird dabei an dem Punkt der Unterkante 11 der Kammer 2 bestimmt, der auf einer Senkrechten den größten Abstand zur Oberkante 12 der Kammer 2 hat. Es versteht sich, dass x₁ und x₂ nicht exakt gleich sein müssen, sondern das Abweichungen davon möglich sind. Vorzugsweise ist x₁ in etwa gleich x₂, wobei in Fig. 2 x₁ kleiner als x₂ ist. Die Ausdehnung x₃ des Hauptbereiches 3 ist definiert als die Summe aus x₁ und x₂. In Richtung A, also der Querrichtung zur Bezugsrichtung B in der Papierebene, sollte die Ausdehnung der beiden Übergangsbereiche 4, 5 kleiner als die des Hauptbereiches sein. Das ist jedoch nicht zwingend erforderlich, wie Fig. 6 zeigt.

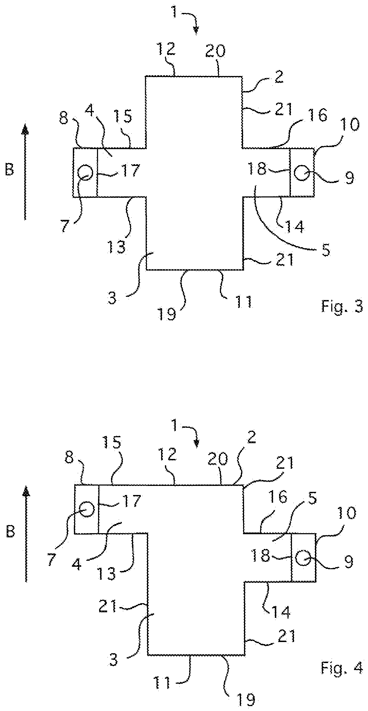

Die in Fig. 3 in vereinfachter Darstellung gezeigte dritte Ausführung der erfindungsgemäßen Vorrichtung 1 entspricht der in Fig. 1 gezeigten ersten Ausführungsform, außer dass Übergangsbereiche 4, 5 versetzt zur Oberkante 12 der Kammer 2 angeordnet sind, so dass ein kreuzförmiger Querschnitt anstelle eines T-förmigen Querschnitts erhalten wird.

Die in Fig. 4 in vereinfachter Darstellung gezeigte vierte Ausführungsform der erfindungsgemäßen Vorrichtung 1 entspricht der in Fig. 1 gezeigten ersten Ausführungsform, außer dass der zweite Übergangsbereich 5 versetzt zur Oberkante 12 der Kammer 2 angeordnet ist, so dass der Querschnitt der Kammer 2 nicht ideal T-förmig ist.

Die in Fig. 5 in vereinfachter Darstellung gezeigte fünfte Ausführungsform der erfindungsgemäßen Vorrichtung 1 entspricht der in Fig. 1 gezeigten ersten Ausführungsform, außer dass die beiden Übergangsbereiche 4, 5 an der Unterkante 11 der Kammer 2 angeordnet sind, so dass die Unterkanten 13, 14 der Übergangsbereiche 4, 5 und die Unterkante 19 des Hauptbereiches 3 gemeinsam die Unterkante 11 der Kammer 2 bilden.

Die in Fig. 6 in vereinfachter Darstellung gezeigte sechste Ausführungsform der erfindungsgemäßen Vorrichtung 1 entspricht der in Fig. 1 gezeigten ersten Ausführungsform, außer dass die Übergangsbereiche 4, 5 in der in der Papierebene liegenden Richtung erkennbar länger sind.

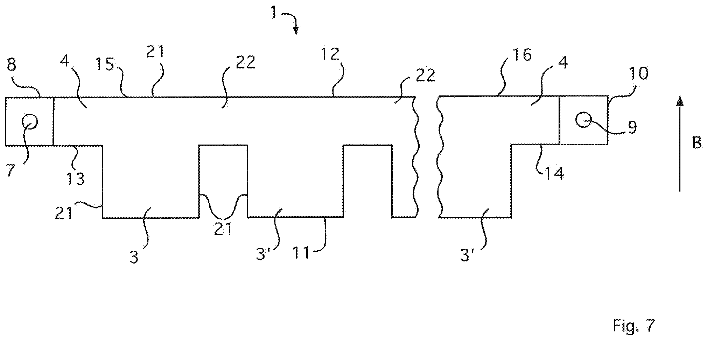

Die in Fig. 7 in vereinfachter Darstellung gezeigte siebente Ausführungsform der erfindungsgemäßen Vorrichtung 1 entspricht der in Fig. 1 gezeigten ersten Ausführungsform, außer dass die Kammer 2 weitere Hauptbereiche 3' aufweist, zwischen denen dritte Übergangsbereiche 22 ausgebildet sind. Die Oberkante 12 der Kammer 2 bildet gleichzeitig die Oberkante der dritten Übergangsbereiche 22, deren Unterkante in der Höhe der Unterkanten 13, 14 des ersten und zweiten Übergangsbereiches 4, 5 liegt.

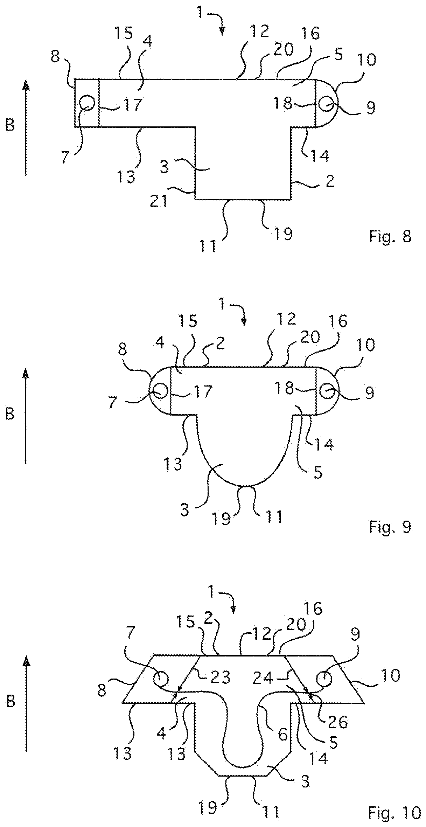

Die in Fig. 8 in vereinfachter Darstellung gezeigte achte Ausführungsform der erfindungsgemäßen Vorrichtung 1 entspricht der in Fig. 1 gezeigten ersten Ausführungsform, außer dass die Ausdehnung des ersten Übergangsbereiches 4 in der in der Papierebene liegenden Richtung kürzer als die Ausdehnung des zweiten Übergangsbereiches 5 in dieser Richtung ist.

Die in Fig. 9 in vereinfachter Darstellung gezeigte neunte Ausführungsform der erfindungsgemäßen Vorrichtung 1 entspricht der in Fig. 2 gezeigten zweiten Ausführungsform, außer dass die Übergangsbereiche 4, 5 in der in der Papierebene liegenden Richtung erkennbar kürzer sind.

Die in Fig. 10 in vereinfachter Darstellung gezeigte zehnte Ausführungsform der erfindungsgemäßen Vorrichtung 1 entspricht der in Fig. 1 gezeigten ersten Ausführungsform, außer dass die Kammer 2 anstelle der Querwände 17, 18 schräge Wände 23, 24 aufweist, in denen jeweils die mit einem Ventil abgedichtete Durchführung 26 ausgebildet ist. Die Länge der Oberkanten 15, 16 der Übergangsbereiche 4, 5 in der Papierebene ist daher kürzer als die ihrer Unterkanten 13, 14. Zusätzlich weist die Kammer 2 schräge Wände 25 auf, die sich von der Unterkante 11 der Kammer 2 zu den Querwänden 21 des Hauptbereiches 3 erstrecken. In dieser Darstellung ist das Substrat 6 gezeigt.

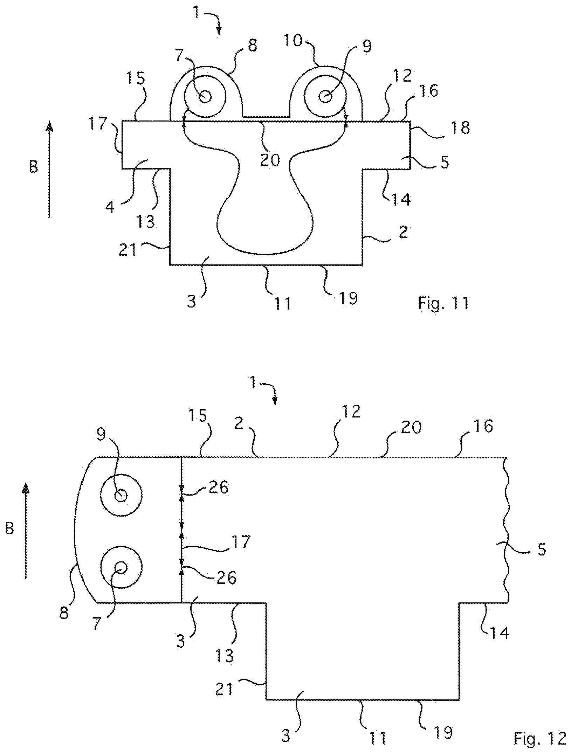

Die in Fig. 11 in vereinfachter Darstellung gezeigte elfte Ausführungsform der erfindungsgemäßen Vorrichtung 1 entspricht der in Fig. 1 gezeigten ersten Ausführungsform, außer dass der Abwickler 7 und der Aufwickler 9 nicht an den Querwänden 17, 18 der Übergangsbereiche 4, 5 befestigt sind, sondern an der Oberkante 12 der Kammer, und zwar an der Oberkante 20 des Hauptbereiches 3. Die abgedichteten Durchführungen für das Substrat 6 befinden sich in der Oberkante 20 des Hauptbereiches 3. Die Wicklergehäuse 8, 10 sind an der Oberkante 12 der Kammer 2 befestigt.

Die in Fig. 12 in vereinfachter Darstellung gezeigte zwölfte Ausführungsform der erfindungsgemäßen Vorrichtung 1 entspricht der in Fig. 1 gezeigten ersten Ausführungsform, außer dass der Abwickler 7 und der Aufwickler 9 in einem gemeinsamen Wicklergehäuse untergebracht sind. In der Querwand 17 des ersten Übergangsbereiches befinden sich zwei abgedichtete Durchführungen 26, so dass das Substrat 6 (nicht gezeigt) vom Abwickler 7 durch die erste Durchführung 26 in den ersten Übergangsbereich 4 und dann in den Hauptbereich 3 geführt werden kann und von dort wiederum durch den ersten Übergangsbereich 4 zur zweiten Durchführung 26 und dann zum Aufwickler 8 geführt wird. Ein zweites Wicklergehäuse 10 ist nicht vorgesehen.

Bei einer Abwandlung der in Fig. 12 gezeigten Ausführungsform ist vorgesehen, dass sich anstelle des Aufwicklers 9 ein zweiter Abwickler befindet. Darüber hinaus sind zwei Aufwickler vorgesehen, die an der Querwand 18 des zweiten Übergangsbereiches 5 befestigt sind. Damit können zwei flexible Substrate gleichzeitigt in der Kammer 2 bearbeitet werden, die von den beiden Abwicklern durch Durchführungen in der Querwand 17 des ersten Übergangsbereiches 4 in den Hauptbereich, von dort in den zweiten Übergangsbereich und durch Durchführungen in der Querwand 18 zu den daran befestigten Aufwickler 9 geführt werden.

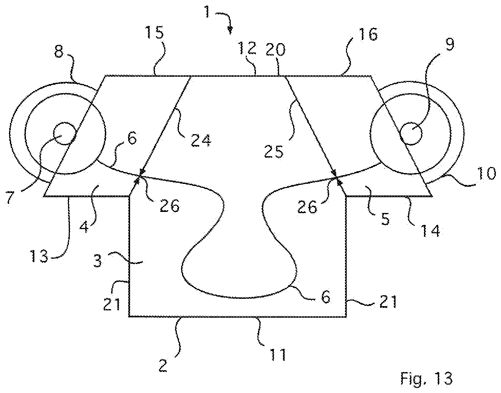

Die in Fig. 13 in vereinfachter Darstellung gezeigte dreizehnte Ausführung der erfindungsgemäßen Vorrichtung 1 entspricht der in Fig. 10 gezeigten zehnten Ausführungsform, außer dass die Schrägwände 24 und 25 in die Kammer 2 versetzt worden sind, wodurch der Abwickler 7 und der Aufwickler 9 näher am Hauptbereich 3 der Kammer 2 angeordnet werden können. Die Wicklergehäuse 8, 10 sind als Hauben ausgebildet. Damit sind die Coils jeweils in einem Raum angeordnet, der von den Hauben und den Übergangsbereichen 4, 5 gebildet wird. Diese Hauben können als Türen ausgebildet sein. Die in Fig. 13 gezeigte Ausführungsform bietet eine besonders gute Zugänglichkeit der Coils. In dieser Ausführungsform gelangt das flexible Substrat 6 von dem Abwickler 7 in den ersten Übergangsbereich 4, bevor es über die Durchführung 26 in Schrägwand 24 in den Hauptbereich 3 eintritt. Von dort gelangt das Substrat 6 über Durchführung 26 in Schrägwand 25 in den zweiten Übergangsbereich 5 und zu dem Aufwickler 9.

Fig. 14 veranschaulicht eine vierzehnte Ausführungsform der erfindungsgemäßen Vorrichtung, die auf der zweiten Ausführungsform basiert. Es ist in Fig. 14 zu erkennen, dass in der Kammer 2 Rollen 27 als Mittel zur Führung des flexiblen Substrates 6 vom Abwickler 7 zum Aufwickler 9 ausgebildet sind. Ferner sind im Hauptbereich 3 der Kammer 2 als Prozessstationen (PS) bezeichnete Einrichtungen zur Bearbeitung des Substrates 6 angeordnet, die zweckmäßigerweise eine identische Geometrie aufweisen, um gleichmäßige und reproduzierbare Prozessergebnisse zu erhalten. Schließlich ist in Fig. 14 zu erkennen, dass die erfindungsgemäße Vorrichtung 1 oberhalb des Bodens befestigt ist, zweckmäßigerweise in einer Höhe, die es einem Menschen ein aufrechtes Stehen unterhalb der Übergangsbereiche 4, 5 ermöglicht. Die Vorrichtung kann beispielsweise an der Decke oder einer Wand befestigt sein. Ferner ist eine schwenkbare Tür 28 im Wicklergehäuse 9 eingezeichnet, die den Zugang zum Abwickler 7 von unten erlaubt. Eine schwenkbare Tür 29 im Wicklergehäuse 10 erlaubt gleichermaßen den Zugang zum Aufwickler 9 von unten. Die Wandungen der Kammer 2 sind erkennbar stärker als die der Wicklergehäuse, da sich die Bedingungen in der Kammer hinsichtlich Druck, Temperatur, Zusammensetzung eines Gases oder Gasgemisches oder Kombinationen davon von den Bedingungen der Umgebung, die auch in den Wicklergehäusen herrschen typischerweise unterscheiden, um die erwünschte Behandlung des Substrates 6 vornehmen zu können.

Eine Bahn des flexiblen Substrates 6 wird vom Abwickler 7, der sich im Wicklergehäuse 8 befindet, abgewickelt und tritt über eine erste Durchführung 26, die mit einem Ventil abgedichtet ist, in den ersten Übergangsbereich 4 ein, der zur Veranschaulichung durch eine gestrichelte Linie von dem Hauptbereich abgrenzt ist. Der erste Übergangsbereich ist in Fig. 14 mit dem Buchstaben "V" gekennzeichnet, weil in diesem Bereich eine Vorbehandlung des Substrates 6 vorgesehen sein kann. Aus dem ersten Übergangsbereich 4 wird die Bahn dann in den Hauptbereich 3 geführt, in dem das Substrat 6 in den Prozessstationen (PS) bearbeitet wird. Der Hauptbereich 3 bildet die Prozesssektion P der Vorrichtung 1. Aus dem Hauptbereich 3 wird die Bahn in den zweiten Übergangsbereich geführt, in dem eine Nachbehandlung stattfinden kann oder eine Messeinrichtung angeordnet sein kann, die den Erfolg der Bearbeitung des Substrates prüfen soll. Der zweite Übergangsbereich ist mit dem Buchstaben N gekennzeichnet. Schließlich verlässt die Bahn durch eine zweite Durchführung 26, die mit einem Ventil abgedichtet ist, den zweiten Übergangsbereich 5, gelangt in das Wicklergehäuse 10 und wird dort auf den Aufwickler 9 aufgewickelt. Es ist in Fig. 14 zu erkennen, dass die Flächenseiten der Bahn des flexiblen Substrates 6 im Wesentlichen parallel zum Boden geführt werden.

In Fig. 14a ist zur weiteren Veranschaulichung der in Fig. 14 gezeigten Ausführungsform zusätzlich die Prozesswalze 35 eingezeichnet, an der das flexible Substrat, während es Prozessstationen (PS) passiert, mit einer Flächenseiten anliegt. Die andere Flächenseite des flexiblen Substrates wird mittels der Prozessstationen (PS) bearbeitet. Es ist in den Figuren 14 und 14 a zu erkennen, dass sich die Prozessstationen (PS) in einem Teilbereich des Hauptbereiches 3 befinden, der nicht an die Übergangsbereiche 4, 5 angrenzt, während sich in dem Teilbereich des Hauptbereiches 3, der die Übergangsbereiche 4, 5 angrenzt, Elemente des Wickelwerkes befinden. Es ist in den Figuren 14 und 14a ferner zu erkennen, dass die Unterkante 19 des Hauptbereiches 3 mit ihrer gekrümmten Geometrie der Geometrie der Prozesswalze 35 folgt. Dabei ist die Krümmung der Unterkante 19 konzentrisch zur Prozesswalze 35 ausgebildet. Die Geometrie der Vorrichtung 1 und insbesondere der Kammer 2 sowie die Anordnung der Prozessstationen in einem Teilbereich des Hauptbereiches 3 und des Wickelwerkes in einem anderen Teilbereich des Hauptbereiches ermöglichen eine gute Zugänglichkeit der Prozessstationen und eine kompakte Bauweise der Vorrichtung 1.

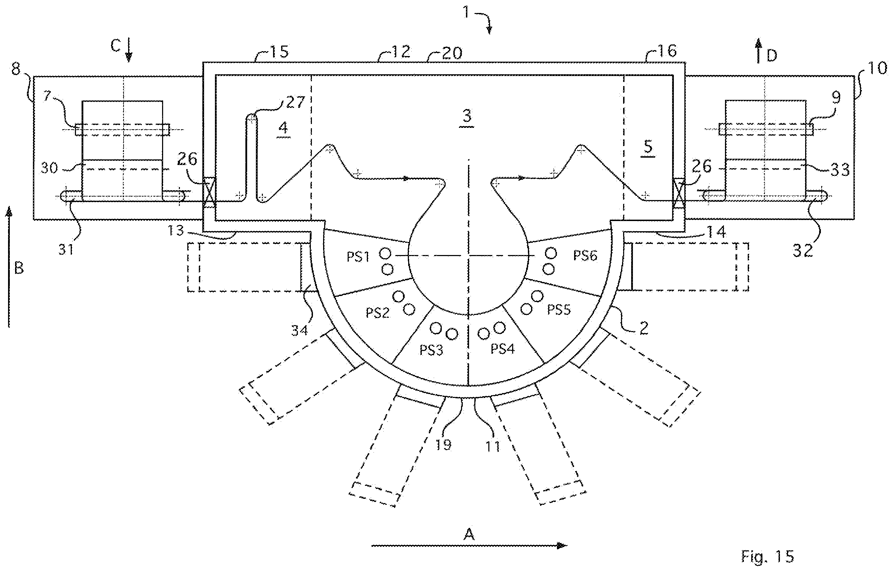

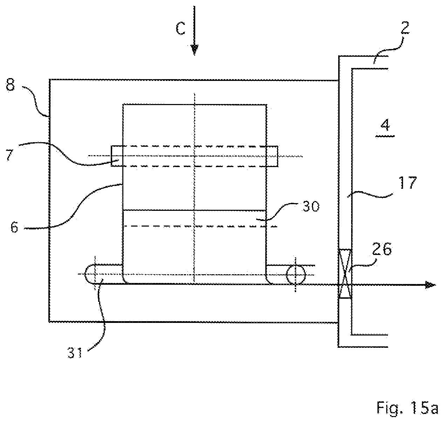

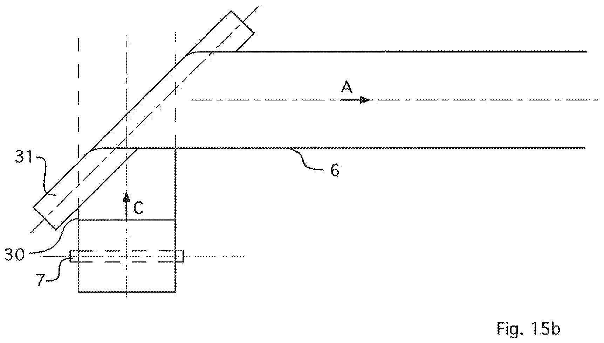

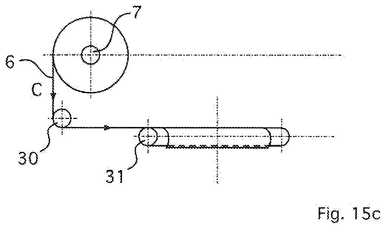

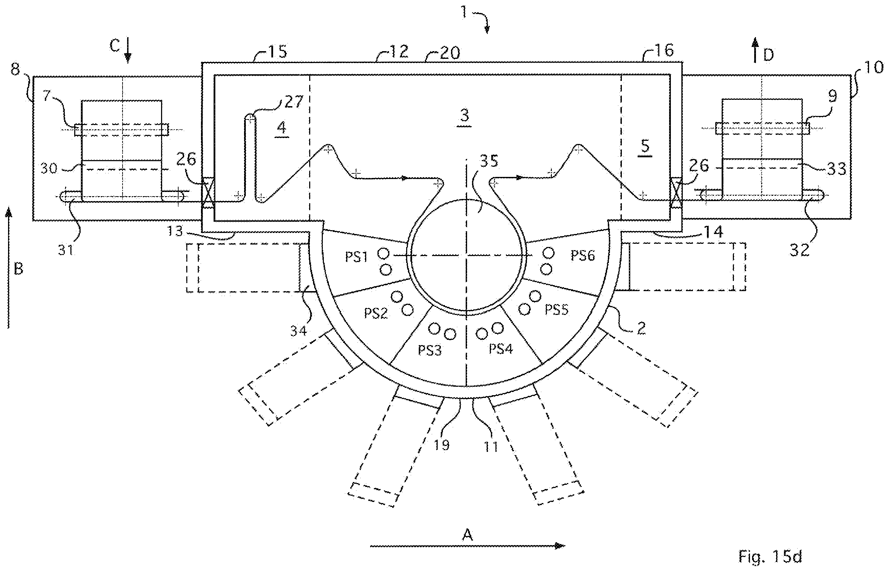

Bei der in Fig. 15 gezeigten fünfzehnten Ausführungsform wird die Bahn des flexiblen Substrates 6 hingegen mit ihren Flächenseiten senkrecht zum Boden geführt. Die Bezugsrichtung B ist nicht, wie in Fig. 14, eine Flächennormale zum Boden, sondern verläuft parallel zum Boden. In dieser Ausführungsform verlaufen die Rotationsachsen der Abwickler 7 und der Aufwickler 9 nicht parallel zu den Querwänden 17, 18 der Übergangsbereiche 4, 5, wie dies in Fig. 14 gezeigt ist, sondern liegen auf einer Flächennormale zu den Querwänden 17, 18. Im Verhältnis zu Fig. 14 "liegt" die Kammer 2 auf der Seite. Um das flexible Substrat in der gezeigten Weise durch die Kammer 2 führen zu können, sind allerdings Umlenkrollen, die starr oder angetrieben sein können, erforderlich.

In Fig. 15 sind eine erste Umlenkrolle 30 und eine zweite Umlenkrolle 31 vorgesehen, die beide in dem Wicklergehäuse 8 angeordnet sind (siehe auch Figuren 15a, 15b und 15c). Die Rotationsachse der ersten Umlenkrolle 30 verläuft dabei parallel zur Rotationsachse des Abwicklers 7. Die Bahn des flexiblen Substrates wird in Richtung des Pfeils C von dem Abwickler 7 abgewickelt und mittels der ersten Umlenkrolle 30 von dem Abwickler 7 weggeführt. Anschließend wird es von der ersten Umlenkrolle 30 zur zweiten Umlenkrolle 31 geführt, deren Rotationsachse in derselben Ebene wie die Rotationsachse der ersten Umlenkrolle 30 liegt, aber in einem spitzen Neigungswinkel dazu angeordnet ist, der in Richtung des ersten Übergangsbereiches 4 hin geöffnet ist. Dabei liegt die Substratbahn auf der Umlenkrolle 31 mit einem Umschlingungswinkel von 180° auf. Mittels der Umlenkrolle 31 wird mittels der 90°-Umlenkung erreicht, dass die Substratbahn, deren Flächenseiten in Fig. 15 zunächst in der Papierebene oder parallel dazu liegen, in eine Lage überführt wird, in der ihre Flächenseiten senkrecht zur Papierebene liegen.

Der in Fig. 15 gezeigte spitze Winkel zwischen den beiden Umlenkrollen 30, 31 beträgt 45°. Es können aber auch andere spitze Winkel vorgesehen sein oder mehrere Umlenkrollen, die die zweite Umlenkrolle ersetzen und deren Funktionen übernehmen, beispielsweise zwei Umlenkrollen mit je 22,5° Neigungswinkel.

Anschließend tritt die Substratbahn durch eine erste Durchführung 26, die mit einem Ventil abgedichtet ist, in den ersten Übergangsbereich 4 ein, der zur Veranschaulichung durch eine gestrichelte Linie von dem Hauptbereich 3 abgrenzt ist. Der erste Übergangsbereich ist in Fig. 15 mit dem Buchstaben "V" gekennzeichnet, weil in diesem Bereich eine Vorbehandlung des Substrates 6 vorgesehen sein kann. Aus dem ersten Übergangsbereich 4 wird die Bahn dann in den Hauptbereich 3 geführt, in dem das Substrat 6 in den Prozessstationen (PS) bearbeitet wird. Der Hauptbereich 3 bildet die Prozesssektion P der Vorrichtung 1. Aus dem Hauptbereich 3 wird die Bahn in den zweiten Übergangsbereich geführt, in dem eine Nachbehandlung stattfinden kann oder eine Messeinrichtung angeordnet sein kann, die den Erfolg der Bearbeitung des Substrates prüfen soll. Der zweite Übergangsbereich ist mit dem Buchstaben N gekennzeichnet. Schließlich verlässt die Bahn durch eine zweite Durchführung 26, die mit einem Ventil abgedichtet ist, den zweiten Übergangsbereich 5 und gelangt in das Wicklergehäuse 10. Dort sind eine dritte und vierte Umlenkrolle 32, 33 vorgesehen, die wiederum eine Änderung der Ausrichtung der Flächenseite der Substratbahn bewirken. Dabei gelangt die Substratbahn zunächst zur dritten Umlenkrolle 32, deren Rotationsachse in derselben Ebene wie die Rotationsachse der vierten Umlenkrolle 33 liegt, aber in einem spitzen Winkel dazu angeordnet, der in Richtung des zweiten Übergangsbereiches 5 hin geöffnet ist. Von dort gelangt die Substratbahn zur vierten Umlenkrolle 33, deren Rotationsache parallel zur Rotationsachse des Aufwicklers 9 verläuft. Anschließend kann die Substratbahn in Pfeilrichtung D von dem Aufwickler 9 aufgewickelt werden.

In Fig. 15 sind ferner Türen 34 eingezeichnet, die jeweils einen Zugang zu den Prozesssektionen (PS), die sich im Hauptbereich 3 der Kammer 2 befinden, erlauben. Es ist zu erkennen, dass der T-förmige Querschnitt einen leichten Zugang zu den Prozesssektionen ermöglicht. Die Türen 34, die Öffnungen (nicht gezeigt) in der "Unterkante" 11 der Kammer 2 verschließen, sind im geschlossenen Zustand gezeigt. Der geöffnete Zustand ist durch Strichlinien angedeutet. Die Türen können mittels Schienen am Boden befestigt sein. Der Boden liegt in Fig. 15 in einer Ebene parallel zur Papierebene und damit unterhalb der Vorrichtung 1. Der Ausdruck "Unterkante" bezieht sich jedoch auf die Bezugsrichtung B, so dass die Unterkante in Bezug auf den Boden nicht unten liegt, sondern orthogonal zum Boden verläuft.

In Fig. 15d ist zur weiteren Veranschaulichung der in Fig. 14 gezeigten Ausführungsform zusätzlich die Prozesswalze 35 eingezeichnet, an der das flexible Substrat, während es Prozessstationen (PS) passiert, mit einer Flächenseiten anliegt. Die andere Flächenseite des flexiblen Substrates wird mittels der Prozessstationen (PS) bearbeitet. Es ist in den Figuren 15 und 15d zu erkennen, dass sich die Prozessstationen (PS) in einem Teilbereich des Hauptbereiches 3 befinden, der nicht an die Übergangsbereiche 4, 5 angrenzt, während sich in dem Teilbereich des Hauptbereiches 3, der an die Übergangsbereiche 4, 5 angrenzt, Elemente des Wickelwerkes befinden. Es ist in den Figuren 14 und 14a ferner zu erkennen, dass die Unterkante 19 des Hauptbereiches 3 mit ihrer gekrümmten Geometrie der Geometrie der Prozesswalze 35 folgt. Dabei ist die Krümmung der Unterkante 19 konzentrisch zur Prozesswalze 35 ausgebildet. Die Geometrie der Vorrichtung 1 und insbesondere der Kammer 2 sowie die Anordnung der Prozessstationen in einem Teilbereich des Hauptbereiches 3 und des Wickelwerkes in einem anderen Teilbereich des Hauptbereiches ermöglichen eine gute Zugänglichkeit der Prozessstationen und eine kompakte Bauweise der Vorrichtung 1.

### Bezugszeichenliste

1 Vorrichtung
2 Kammer
3 Hauptbereich
3' weiterer Hauptbereich
4 erster kanalförmiger Übergangsbereich
5 zweiter kanalförmiger Übergangsbereich
6 bandförmiges flexibles Substrat
7 Abwickler
8 Wicklergehäuse für den Abwickler
9 Aufwickler
10 Wicklergehäuse für den Aufwickler
11 Unterkante der Kammer
12 Oberkante der Kammer
13 Unterkante des ersten Übergangsbereiches
14 Unterkante des zweiten Übergangsbereiches
15 Oberkante des ersten Übergangsbereiches
16 Oberkante des zweiten Übergansbereiches
17 Querwand des ersten Übergangsbereiches
18 Querwand des zweiten Übergangsbereiches
19 Unterkante des Hauptbereiches
20 Oberkante des Hauptbereiches
21 Querwand des Hauptbereiches
22 Übergangsbereich zwischen zwei Hauptbereichen
24 Schrägwand des ersten Übergangsbereiches
25 Schrägwand des zweiten Übergangsbereiches
26 abgedichtete Durchführung
27 Rolle
28 Tür
29 Tür
30 Umlenkrolle
31 Umlenkrolle
32 Umlenkrolle
33 Umlenkrolle
34 Tür am Hauptbereich der Kammer
35 Prozesswalze

## Patentansprüche

1. Vorrichtung zum Bearbeiten flexibler, bandförmiger Substrate (6), wobei die Vorrichtung (1) eine Kammer (2) für die Bearbeitung des flexiblen Substrates (6), einen Abwickler (7) und einen Aufwickler (9) für das flexible Substrat (6), die außerhalb der Kammer (2) angeordnet sind, sowie Mittel zur Führung des flexiblen Substrates (6) vom Abwickler (7) zum Aufwickler (9) aufweist, wobei die Kammer (2) zumindest eine abgedichtete Durchführung (26) zum Führen des flexiblen Substrates (6) in die Kammer (2) und/oder aus der Kammer (2) besitzt, **dadurch gekennzeichnet, dass** die Kammer (2) einen Hauptbereich (3) und zumindest einen kanalförmigen Übergangsbereich (4, 5) aufweist, dessen Ausdehnung (x₁) in zumindest einer Richtung, der Bezugsrichtung (B), geringer als die Ausdehnung (x₃) des Hauptbereiches (3) in derselben Richtung ist, und dass der Abwickler (7) und der Aufwickler (9) an der Außenwand der Kammer (2) befestigt sind, wobei die Vorrichtung keine Wicklergehäuse mit Zwischenkammern oder separaten Vakuumkammern, die von einem im Abwickler (7) oder Aufwickler (9) befindlichen Coil abtrennbar sind und in denen Temperatur- und/oder Druckverhältnisse geschaffen werden können, die sich von dem Raum unterscheiden, in dem sich das jeweilige Coil befindet, aufweist.

2. Vorrichtung nach Anspruch 1, **dadurch gekennzeichnet, dass** der Abwickler (7) und der Aufwickler (9) in einem gemeinsamen oder separaten Wicklergehäusen (8, 10) angeordnet sind.

3. Vorrichtung nach Anspruch 1 oder Anspruch 2, **dadurch gekennzeichnet, dass** an den kanalförmigen Übergangsbereich (4, 5) ein Wicklergehäuse (8, 10) angrenzt und die Ausdehnung des Wicklergehäuses (8, 10) die Ausdehnung (x₁) des Übergangsbereiches (4, 5) in der Bezugsrichtung (B) nicht übersteigt.

4. Vorrichtung nach einem der vorstehenden Ansprüche, **dadurch gekennzeichnet, dass** sie zwei kanalförmige Übergangsbereiche (4, 5) aufweist, zwischen denen der Hauptbereich (3) liegt.

5. Vorrichtung nach Anspruch 4, **dadurch gekennzeichnet, dass** die beiden Übergangsbereiche (4, 5) in derselben Höhe oder versetzt zueinander, jeweils bezogen auf die Bezugsrichtung (B), ausgebildet sind.

6. Vorrichtung nach Anspruch 4 oder Anspruch 5, **dadurch gekennzeichnet, dass** das Wicklergehäuse (8) des Abwicklers (7) an den ersten Übergangsbereich (4) angrenzt und dass das Wicklergehäuse (9) des Aufwicklers (10) an den zweiten Übergangsbereich (5) angrenzt.

7. Vorrichtung nach Anspruch 4 oder Anspruch 5, **dadurch gekennzeichnet, dass** das Wicklergehäuse (8) des Abwicklers (7) an den ersten Übergangsbereich (4) angrenzt und an den zweiten Übergangsbereich (5) ein weiterer Hauptbereich (3') angrenzt.

8. Vorrichtung nach einem der vorstehenden Ansprüche, **dadurch gekennzeichnet, dass** das oder die Wicklergehäuse (8, 10) an die Seite des Übergangsbereiches (4, 5) angrenzen, die dem Hauptbereich (3) abgewandt ist.

9. Vorrichtung nach einem der vorstehenden Ansprüche, **dadurch gekennzeichnet, dass** die maximale Ausdehnung (x₁) des oder der Übergangsbereiche (4, 5) in der Bezugsrichtung (B) 50 % der Ausdehnung (x₃) des Hauptbereiches (3) in der Bezugsrichtung (B) oder weniger beträgt.

10. Vorrichtung nach einem der vorstehenden Ansprüche, **dadurch gekennzeichnet, dass** die Ausdehnung des oder der Übergangsbereiche (4, 5) in einer Richtung orthogonal zur Bezugsrichtung (B) der Ausdehnung des Hauptbereiches (3) in dieser orthogonalen Richtung entspricht.

11. Vorrichtung nach einem vorstehenden Ansprüche, **dadurch gekennzeichnet, dass** die Kammer (2) einen T-förmigen oder kreuzförmigen Querschnitt aufweist.

12. Vorrichtung nach einem der vorstehenden Ansprüche, **dadurch gekennzeichnet, dass** in dem oder den Wicklergehäusen (8, 10) verschließbare Öffnungen (26) ausgebildet sind, die eine Ein- oder Ausbringung von Rollen des flexiblen Materials (6) gestatten.

13. Vorrichtung nach einem der vorstehenden Ansprüche, **dadurch gekennzeichnet, dass** Mittel (30, 31, 32, 33) zur Änderung der Ausrichtung der Substratbahn, bezogen auf deren Flächenseiten, aus einer ersten Ebene in eine zweite, orthogonale Ebene vorgesehen sind.

14. Vorrichtung nach Anspruch 13, **dadurch gekennzeichnet, dass** die Längsachse der Substratbahn in der ersten Ebene und die Längsachse der Substratbahn in der zweiten Ebene in einer Ebene oder parallelen Ebenen liegen.

## Claims

1. A device for processing flexible, band-shaped substrates (6), wherein the device (1) has a compartment (2) for processing the flexible substrate (6), an unwinder (7) and a rewinder (9) for the flexible substrate (6) that are arranged outside of the compartment (2), as well as means for guiding the flexible substrate (6) from the unwinder (7) to the rewinder (9), wherein the compartment (2) has at least one sealed bushing (26) for guiding the flexible substrate (6) into the compartment (2) and/or from the compartment (2), **characterized in that** the compartment (2) has a main region (3) and at least one channel-shaped transition region (4, 5) the extension (x₁) of which in at least one direction, the reference direction (B), is smaller than the extension (x₃) of the main region (3) in the same direction, and that the unwinder (7) and the rewinder (9) are attached to the outer wall of the compartment (2), wherein the device has no winder casing with intermediate compartments or separate vacuum compartments that can be separated from a coil located in the unwinder (7) or rewinder (9) and in which temperature and/or pressure conditions can be generated that differ from the space in which the respective coil is located.

2. The device according to claim 1, **characterized in that** the unwinder (7) and the rewinder (9) are arranged in a common or separate winder casings (8, 10).

3. The device according to claim 1 or claim 2, **characterized in that** a winder casing (8, 10) abuts on the channel-shaped transition region (4, 5) and the extension of the winder casing (8, 10) does not exceed the extension (x₁) of the transition region (4, 5) in the reference direction (B).

4. The device according to any of the preceding claims, **characterized in that** it has two channel-shaped transition regions (4, 5) between which there is the main region (3).

5. The device according to claim 4, **characterized in that** the two transition regions (4, 5) are formed at the same height or offset to each other relative to the reference direction (B).

6. The device according to claim 4 or claim 5, **characterized in that** the winder casing (8) of the unwinder (7) abuts on the first transition region (4) and that the winder casing (9) of the rewinder (10) abuts on the second transition region (5).

7. The device according to claim 4 or claim 5, **characterized in that** the winder casing (8) of the unwinder (7) abuts on the first transition region (4) and a further main region (3') abuts on the second transition region (5).

8. The device according to any of the preceding claims, **characterized in that** the winder casing(s) (8, 10) abut on the side of the transition region (4, 5) that faces away from the main region (3).

9. The device according to any of the preceding claims, **characterized in that** the maximum extension (x₁) of the transition region(s) (4, 5) in the reference direction (B) is 50% of the extension (x₃) of the main region (3) in the reference direction (B) or less.

10. The device according to any of the preceding claims, **characterized in that** the extension of the transition region(s) (4, 5) in a direction orthogonal to the reference direction (B) corresponds to the extension of the main region (3) in said orthogonal direction.

11. The device according to any of the preceding claims, **characterized in that** compartment (2) has a T-shaped or cross-shaped cross section.

12. The device according to any of the preceding claims, **characterized in that** closable openings (26) are formed in the winder casing(s) (8, 10) to permit reels of the flexible material (6) to be placed or removed.

13. The device according to any of the preceding claims, **characterized in that** means (30, 31, 32, 33) for changing the orientation of the substrate web with respect to its surface sides from a first plane into a second orthogonal plane are provided.

14. The device according to claim 13, **characterized in that** the longitudinal axis of the substrate web in the first plane and the longitudinal axis of the substrate web in the second plane lie in one plane or parallel planes.

## Revendications

1. Dispositif de traitement de substrats flexibles, sous forme de bande (6), le dispositif (1) comprenant une chambre (2) pour le traitement du substrat flexible (6), un dérouleur (7) et un enrouleur (9) pour le substrat flexible (6) positionnés à l'extérieur de la chambre (2), ainsi que des moyens de guidage du substrat flexible (6) du dérouleur (7) vers l'enrouleur (9), la chambre (2) comportant au moins une traversée isolée de façon étanche (26) pour guider le substrat flexible (6) dans la chambre (2) et/ou hors de la chambre (2), **caractérisée en ce que** la chambre (2) présente une zone principale (3) et au moins une zone de transition (4, 5) en forme de canal, dont l'étendue (x₁) dans au moins une direction, soit la direction de référence (B), est inférieure à l'étendue (x₃) de la zone principale (3) dans la même direction, et le dérouleur (7) et l'enrouleur (9) sont montés sur la paroi externe de la chambre (2), le dispositif ne disposant pas de boîtiers enrouleurs avec chambres de transition ou de chambres à vide distinctes qui sont séparables d'une bobine du dérouleur (7) ou de l'enrouleur (9) et dans lesquelles les taux de température et/ou de compression peuvent être réglés, qui diffèrent de la chambre dans laquelle se trouve chaque bobine.

2. Dispositif selon la revendication 1, **caractérisée en ce que** le dérouleur (7) et l'enrouleur (9) soient positionnés dans un boîtier enrouleur en commun ou distinct (8, 10).

3. Dispositif selon la revendication 1 ou la revendication 2, **caractérisé en ce qu'**un boîtier enrouleur (8, 10) soit adjacent à la zone de transition en forme de canal (4, 5) et que l'étendue (x₁) du boîtier enrouleur (8, 10) soit inférieure à l'étendue à la zone de transition (4, 5) dans la direction de référence (B).

4. Dispositif selon l'une des revendications précédentes, **caractérisé en ce qu'**il présente deux zones de transition (4, 5) en forme de canal, entre lesquelles est située la zone principale (3).

5. Dispositif selon la revendication 4, **caractérisé en ce que** les deux zones de transition (4, 5) soient disposées à la même hauteur ou décalées à distance l'une de l'autre, dans chaque cas par rapport à la direction de référence (B).

6. Dispositif selon la revendication 4 ou la revendication 5, **caractérisé en ce que** le boîtier enrouleur (8) du dérouleur (7) est adjacent à la zone de transition (4) et **en ce que** le boîtier (9) de l'enrouleur (10) est adjacent à la deuxième zone de transition (5).

7. Dispositif selon la revendication 4 ou la revendication 5, **caractérisé en ce que** le boîtier enrouleur (8) du dérouleur (7) est adjacent à la première zone de transition (4) et qu'une zone principale supplémentaire (3') est adjacente à une deuxième zone de transition (5).

8. Dispositif selon l'une des revendications précédentes, **caractérisé en ce que** le ou les boîtiers enrouleurs (8, 10) sont adjacents au côté de la zone de transition (4, 5) qui est opposée à la zone principale (3).

9. Dispositif selon l'une des revendications précédentes, **caractérisé en ce que** l'étendue maximale (x₁) de ou des zones de transition (4, 5) dans la direction de référence (B) comporte 50 % ou moins de l'étendue (x₃) de la zone principale (3) dans la direction de référence (B).

10. Dispositif selon l'une des revendications précédentes, **caractérisé en ce que** l'étendue de la zone ou des zones de transition (4, 5) dans la direction orthogonale vers la direction de référence (B) de l'étendue de la zone principale (3) correspond à cette direction orthogonale.

11. Dispositif selon l'une des revendications précédentes, **caractérisé en ce que** la chambre (2) présente une forme de section transversale en forme de T ou de croix.

12. Dispositif selon l'une des revendications précédentes, **caractérisé en ce que** dans le ou les boîtiers enrouleurs (8, 10) il y a des ouvertures à verrouiller (26) permettant d'insérer ou de retirer des rouleaux de matériel flexible (6).

13. Dispositif selon l'une des revendications précédentes, **caractérisé en ce que** les moyens (30, 31, 32, 33) pour la modification du positionnement de la bande de substrat, se rapportant aux côtés de la surface à partir de laquelle est prévu un plan orthogonal d'un premier plan vers un deuxième un plan.

14. Dispositif selon la revendication 13, **caractérisé en ce que** l'axe longitudinal de la bande de substrat dans le premier plan et l'axe longitudinal de la bande de substrat du second plan sont positionnées dans un plan ou des plans parallèles.
